# EUROPÄISCHE PATENTSCHRIFT

(11) **EP 4 074 920 B1**
(45) Veröffentlichungstag und Bekanntmachung des Hinweises auf die Patenterteilung: **07.08.2024**
(21) Anmeldenummer: 21168932.8
(22) Anmeldetag: 16.04.2021
(51) Int. Cl.: E04G 9/02, B28B 7/00, B28B 23/00, B28B 17/00, B28B 23/02, E04C 5/08, E04C 5/12, G06F 30/13

(54) **VERFAHREN UND SYSTEM ZUM HERSTELLEN EINES BETON-BAUTEILS ODER BAUABSCHNITTS NACH PLANUNGSDATEN UND VERWENDUNG**
METHOD AND SYSTEM FOR PRODUCING A CONCRETE COMPONENT OR CONSTRUCTION SECTION ACCORDING TO PLANNING DATA AND USE
PROCÉDÉ ET SYSTÈME DE FABRICATION D'UN COMPOSANT EN BÉTON OU D'UNE SECTION DE CONSTRUCTION SELON LES DONNÉES DE PLANIFICATION ET UTILISATION

(43) Veröffentlichungstag der Anmeldung: 19.10.2022
(73) Patentinhaber: Schöck Bauteile GmbH, 76534 Baden-Baden (DE)
(72) Erfinder: Fritschi, Hubert, 76530 Baden-Baden (DE)
(74) Vertreter: König Szynka Tilmann von Renesse Patentanwälte Partnerschaft mbB Düsseldorf

(56) Entgegenhaltungen:
- EP-A1- 3 779 875
- EP-B1- 3 135 840
- CN-A- 112 343 352
- CN-A- 112 412 015
- DE-A1- 19 603 684
- JP-B2- 6 399 638

## Beschreibung

Die Erfindung betrifft ein Verfahren zum Herstellen eines mittels Planungsdaten geplanten Beton-Bauteils oder Bauabschnitts, eine Verwendung eines Schalungselements und eines Bewehrungselements bei der Herstellung eines mittels Planungsdaten geplanten Beton-Bauteils oder Bauabschnitts und ein System zur Herstellung eines mittels Planungsdaten geplanten Beton-Bauteils oder Bauabschnitts.

Es ist bekannt, Beton-Bauteile oder Bauabschnitte mittels einer Anordnung einer Schalung mit einer Bewehrung in der Schalung und einem Verfüllen der Schalung zumindest teilweise mit Beton herzustellen. Dazu wird die Bewehrung in der Schalung händisch positioniert und eine Person vergleicht den geplanten Soll-Zustand (den geplanten Zustand) mit dem Ist-Zustand (dem aktuell in der Schalung vorliegenden Zustand). Die Überprüfung erfolgt klassisch durch die Person mittels Messinstrumenten.

Es hat sich gezeigt, dass es in der Praxis häufig zu Fehlern bzw. Abweichungen beim Positionieren der Bewehrung in die geplante Position in der Schalung kommt. Meist liegen die Abweichungen im Bereich von mehr als 5mm. Da diese Abweichungen bekannt sind, wird meist bei der Planung schon eine derartige "Fehlpositionierung" berücksichtigt und die Bewehrung "großzügiger" geplant.

EP 3 135 840 B1 offenbart eine Kletterschalung für ein Bauwerk, das aus nacheinander gegossenen Segmenten besteht. Ein Schalungselement weist einen Informationsträger in Form eines QR-Codes auf, wobei die Lage des Schalungselements durch eine Messeinheit bestimmt wird. Die Lage des Bewehrungselements wird ermittelt bevor das Schalungselement zum nächsten Segment geschoben wird. Die Lage des Bewehrungselementes kann unter Berücksichtigung der Messdaten der bereits gegossenen Betonsegmente korrigiert werden, falls eine Abweichung von der Sollposition vorliegt.

JP 6 399638 B2 offenbart einen Sensor zum Feststellen, ob die Dicke der Bedeckung eines Betonteils, welches eine Stahlarmierung aufweist, einen vorgegebenen Wert aufweist. Es wird ein RFID Tag beschrieben, der an der Armierung angeordnet werden kann. Eine Abnahmebescheinigungsinformation, die den gemessenen Wert des Garantiewerts für eine Bedeckung mit Beton darstellt, kann im internen Speicher des RFID Tags gespeichert werden. Die Information kann berührungslos mit einem Lesegerät von der Oberfläche des Betonteils nach Fertigstellung ausgelesen werden.

DE 196 03 684 A1 offenbart ein Verfahren zum Kennzeichnen von Betonfertigteilen oder Ortbetonbauwerken. Zur Kennzeichnung wird am oder im Betonfertigteil oder Ortbetonbauwerk als Datenträger ein Transponderchip befestigt, in welchen die zur Kennzeichnung notwendigen Daten kontaktlos eingeschrieben werden.

CN 112 412 015 A offenbart ein Beton-Bauteil, welches eine Kennzeichnung hinsichtlich Komponenten-Nummer, Verwendungsort, Höhe, Komponentenlänge, Gewicht und Herstellerinformation beinhaltet.

CN 112 343 352 A offenbart ein intelligentes Steuerungssystem und Steuerungsverfahren für einen kombinierten Wandbau, bei dem sowohl intelligente Handhabungsgeräte als auch intelligente Montagegeräte und intelligente Sprinkleranlagen mit Sensoren ausgestattet sind. Die Sensoren können für die Positionierung und Verfolgung der einzelnen Geräte verwendet werden und dienen einer Digitalisierung des Systems. RFID Tags sind in den Geräten vorhanden und jeder RFID Tag hat einen eindeutigen elektronischen Code, der am Objekt angebracht ist, um das Zielobjekt zu identifizieren.

EP 3 700 79875 A1 offenbart ein computergestütztes Verfahren und eine Einrichtung zum Einmessen von Bauelementen auf einer Baustelle für die Errichtung oder den Ausbau eines Gebäudes. Es wird eine Raumabtastung der Umgebung beschrieben, um ein verzerrungsfreies Bild dieser Umgebung als Ist-Umgebungsbild zu erstellen.

Aufgabe der Erfindung ist es, ein verbessertes Verfahren zum Herstellen eines mittels Planungsdaten geplanten Beton-Bauteils oder Bauabschnitts und ein verbessertes System zur Herstellung eines mittels Planungsdaten geplanten Beton-Bauteils oder Bauabschnitts zu schaffen.

Die Aufgabe wird mittels des Gegenstands der unabhängigen Patentansprüche gelöst. Bevorzugte Ausführungsformen ergeben sich aus den Unteransprüchen und der Beschreibung.

Kerngedanke der vorliegenden Erfindung ist es, eine Hilfestellung für eine korrekte Positionierung der Bewehrung im Schalungsraum anzugeben, wodurch eine bessere Qualität des zu fertigenden Beton-Bauteils bzw. Bauabschnitts erreicht werden kann. An einem Schalungselement und einem Bewehrungselement, welches zur Herstellung des Beton-Bauteils oder Bauabschnitts verwendet wird, ist ein Informationsträger vorgesehen, der es ermöglicht, die Lage des Schalungselements im Raum zu ermitteln, wobei die relative Lage des Schalungselements zum Bewehrungselement im Raum in Abhängigkeit von den Planungsdaten mittels eines Sensors bestimmt wird. Die Informationsträger können von dem Sensor ermittelt bzw. erkannt werden. Mittels des Zusammenwirkens eines Informationsträgers mit einem Sensor kann die Anordnung der relativen Lage des Bewehrungselements zum Schalungselement verbessert werden. Ein jeweils an einem der beiden Elemente vorgesehener Informationsträger kann eine Bestimmung der dreidimensionalen Lage des entsprechenden Elements auch beispielsweise unter problematischen Lichtverhältnissen ermöglichen.

Die Erfindung schafft ein Verfahren nach Anspruch 1
Im Sinne der Beschreibung sind "Planungsdaten" Daten, die einen Soll-Zustand des Beton-Bauteils oder Bauabschnitts beschreiben. Insbesondere können die Planungsdaten die Anordnung eines oder mehrerer Bewehrungselemente im Beton-Bauteil oder Bauabschnitt - und damit zum Schalungselement bzw. in der Schalung - beschreiben. Neben der Lage eines oder mehrerer Bewehrungselemente kann auch die Art des Bewehrungselements, beispielsweise mittels eines Informationsträgers am Bewehrungselement, angegeben werden. Beispielsweise kann angegeben werden, welches Material und/oder welche Abmessung und/oder räumliche Ausgestaltung das Bewehrungselement bzw. die Bewehrungselemente haben können.

Im Sinne Beschreibung umfasst der Begriff "Beton-Bauteil" ein Fertigbauteil zur Verwendung auf einer Baustelle. Das Beton-Bauteil kann neben dem Bewehrungselement oder den Bewehrungselementen mindestens ein weiteres Element, beispielsweise ein für eine Isolierung vorgesehenes Element, umfassen.

Der Begriff "Bauabschnitt" im Sinne der Beschreibung umfasst einen an einer Baustelle zu fertigenden Abschnitt. Der zu fertigende Abschnitt kann neben dem Bewehrungselement oder den Bewehrungselementen mindestens ein weiteres Element, beispielsweise ein für eine Isolierung vorgesehenes Element, umfassen.

Der Begriff "Beton" im Sinne der Beschreibung umfasst den Baustoff "Beton", der als Dispersion unter Zugabe von Flüssigkeit aus einem Bindemittel und Zuschlagstoffen angemischt wird. Der Beton kann ein Zusatzmittel umfassen.

Im Sinne der Beschreibung umfasst der Begriff "Schalungselement" ein Element, welches einen Abschnitt einer Schalung bildet. Die Schalung ist dabei die Gussform, in die der Beton zur Herstellung des Beton-Bauteils oder Bauabschnitts eingebracht wird. Die Anordnung des Schalungselements zum Bewehrungselement bestimmt die Lage des Bewehrungselements im in die Schalung einzufüllenden Beton und damit die Lage des Bewehrungselements im Beton-Bauteil bzw. dem Bauabschnitt.

Der Begriff "Bewehrungselement" umfasst ein Element einer Bewehrung, d.h. einer Verstärkung eines Beton-Bauteils oder Bauabschnitts. Ein Bewehrungselement kann ein stabförmiges, flächiges oder raumförmiges oder 3D-Körperförmiges Element sein. Das Bewehrungselement kann insbesondere Baustahl, Bewehrungsstahl bzw. Betonstahl sein. Es kann auch vorgesehen sein, dass das Bewehrungselement Glasfasern und/oder Kohlenstofffasern und/oder Aramid und/oder Basalt aufweist.

Im Sinne der Beschreibung wird unter dem Begriff "Informationsträger" jede Art von Ausgestaltung verstanden, die es ermöglicht, das Element, an welchem der Informationsträger angeordnet ist, zu identifizieren. Die Lage des Elements wird mit einem mit dem Informationsträger zusammenwirkenden Sensor im Raum insbesondere zunächst relativ zu dem Sensor, ermittelt. Es kann vorgesehen sein, dass der Informationsträger als Struktur am Bewehrungselement oder am Schalungselement angeordnet oder angebracht ist, beispielsweise, wenn als Bewehrungselement ein Element verwendet wird, welches eine äußere Struktur in Form einer Oberflächenstrukturierung aufweist. Sofern der Informationsträger dazu verwendet wird, die Lage des Schalungselements und/oder des Bewehrungselements im Raum zu ermitteln, so wird hierunter verstanden, dass durch die Ermittlung der Informationsträgers im Raum eine Ermittlung der Lage des Elements, an dem sich der Informationsträger befindet, im Raum ermittelt werden kann, wenn bekannt ist, wo und wie der Informationsträger an dem jeweiligen Element angeordnet ist (im Folgenden auch "Struktur"). Insbesondere kann unter einem "Informationsträger" eine strukturelle Ausgestaltung verstanden werden, die fest an dem Schalungselement und/oder dem Bewehrungselement vorliegt.

Der Informationsträger kann eine mit der räumlichen Lage des Informationsträgers verbundene Charakteristik aufweisen, die in einer Datenbank gespeichert sein kann. Beispielweise kann für einen optisch erfassbaren Informationsträger ein Abbild des Informationsträgers unter einem vorgegebenen Winkel und Abstand in der Datenbank hinterlegt sein. Wird der Informationsträger, der an dem Bewehrungselement und/oder dem Schalungselement angebracht ist, dann mittels des Sensors erfasst, so kann durch einen Vergleich mit dem in der Datenbank hinterlegten Abbild die Lage im Raum, die der Informationsträger zum Sensor einnimmt, ermittelt werden.

Im Sinne der Beschreibung wird unter der relativen Lage des Schalungselements zum Bewehrungselement eine Anordnung und Ausrichtung einer Fläche des Schalungselements und/oder einer dreidimensionalen Ausgestaltung am Schalungselement (beispielsweise eine Kante des Schalungselements) zum Bewehrungselement verstanden. Die Fläche kann eine Fläche der Schalung sein, die den eingefüllten Beton kontaktiert. Die dreidimensionale Ausgestaltung kann eine Ecke oder eine Kante der Schalung sein. Sofern die räumliche Ausgestaltung und Erstreckung des Schalungselements beispielsweise mittels einer Struktur oder des Informationsträgers am Schalungselement bestimmt wurde, kann die Lage und Ausrichtung im Raum anhand der Struktur bzw. des Informationsträgers bestimmt werden, so dass auf die geplante Lage und Ausrichtung des Bewehrungselements gemäß den Planungsdaten rückgeschlossen werden kann. Durch die ermittelte Lage des Schalungselements bzw. der Schalung im Raum kann durch die Planungsdaten die Lage des Bewehrungselements festgelegt werden. Die ermittelte Lage des Schalungselements bzw. der Schalung kann unter Verwendung der Planungsdaten die Lage des Bewehrungselements relativ zu dem Schalungselement vorgeben.

Eine "relative Lage im Raum" eines entsprechenden Elements bezeichnet die Anordnung des Elements im Raum, insbesondere zu einem Punkt des Sensors, der die relative Lage im Raum ermittelt, und/oder einem Referenzpunkt, dessen Lage ebenfalls durch den Sensor ermittelt wird. Die Lage im Raum kann eine Festlegung von Punkten des Elements im Raum umfassen. Durch die relative Lage eines Elements im Raum kann die Anordnung, Lage und/oder Orientierung des Elements im Raum festgelegt sein. Die relative Lage des Elements kann mittels Raumpunkten wiedergegeben werden, an denen das Element vorhanden bzw. angeordnet ist. Die relative Lage kann alternativ oder zusätzlich mittels einer für das Element abgespeicherten geometrischen dreidimensionalen Form angegeben werden, wobei zusätzlich ein Punkt der Form im Raum mit einer Orientierung bzw. Ausrichtung der Form im Raum angegeben werden kann.

Im Sinne der Beschreibung ist ein "Sensor" jedwedes technische Bauteil, mit dem die Lage des Schalungselements und/oder Bewehrungselements im Raum bestimmt werden kann. Insbesondere kann es sich bei einem Sensor um einen optischen Sensor, einen akustischen Sensor (Schallsensor), einen mechanischen Sensor, einen taktilen Sensor, einen induktiven Sensor und/oder einen magnetischen Sensor handeln. Es kann auch mehr als ein Sensor vorgesehen sein. Sofern mehr als ein Sensor vorgesehen ist, können die Sensoren unterschiedlicher oder gleicher Art sein. Bevorzugt kann ein Sensor eine Kombination der vorgenannten Ausgestaltungen der Sensoren sein, wobei eine Ausgestaltung mit zwei oder mehr Arten von Sensoren bevorzugt ist. Mittels unterschiedlicher Sensoren und/oder einer Kombination von Sensorarten in einem Sensor können unterschiedliche Ausgestaltungen von Informationsträgern berücksichtigt werden.

In einer bevorzugten Ausführungsform kann das Bewehrungselement, welches bereitgestellt wird, an einem einbaufertigen Bauteil vorliegen. Das einbaufertige Bauteil kann aus der folgenden Gruppe ausgewählt werden: Tragendes Wärmedämmelement, Trittschalldämmelement, thermisch trennendes Befestigungselement, Schub- und Schwerlastdorn, Transportankerhülse, Ankerschiene, Gitterhülse und Durchstanzbewehrung. Hierdurch können in einfacher Weise Beton-Bauteile oder Bauabschnitte mit hoher Qualität gefertigt werden.

Ein virtuelles Bewehrungselement wird in Abhängigkeit der Lage des Schalungselements in das Schalungselement gemäß den Planungsdaten projiziert, sodass eine Hilfestellung in Form der Projektion in das Schalungselement bzw. an das Schalungselement vorliegen kann, die eine Anordnung des (realen) Bewehrungselements vereinfachen kann. Beispielsweise kann das (reale) Bewehrungselement in eine Lage gebracht werden, sodass das virtuelle Bewehrungselement und das reale Bewehrungselement bestmöglich überlappen.

Im Sinne der Beschreibung ist ein "virtuelles Bewehrungselement" eine für einen Anwender erkennbare Angabe der Lage des Bewehrungselements in Bezug auf das Schalungselement bzw. die Schalung gemäß den Planungsdaten. Eine Projektion in diesem Sinne muss nicht vollständig das Bewehrungselement optisch in der Schalung bzw. am Schalungselement wiedergeben; eine Wiedergabe auch nur teilweise, beispielsweise (i) nur ein Abschnitt oder Abschnitte des Bewehrungselements, (ii) nur eine Kontur des Bewehrungselements, (iii) nur Punkte im Raum, durch die das Bewehrungselement verlaufen soll und/oder (iv) zwei Endpunkte des Bewehrungselements, kann ausreichend für eine Hilfestellung zur Anordnung des Bewehrungselements im Raum sein.

In einer bevorzugten Ausführungsform kann vorgesehen sein, dass das Bewehrungselement in Abhängigkeit von der ermittelten Lage des Schalungselements zum Schalungselement automatisch gemäß den Planungsdaten angeordnet wird. Beispielsweise kann das Bewehrungselement im Raum mittels eines Roboterarms gegriffen, bewegt und angeordnet werden. Es kann eine zumindest halbautomatische Fertigung derart vorliegen, dass die Anordnung des Bewehrungselements mittels einer Vorrichtung durchgeführt wird, die Daten empfängt, die mit den Daten des Sensors, der die Lage des Schalungselements im Raum ermittelt, korrespondieren und diese Daten verwendet werden, um die Anordnung des Bewehrungselements gemäß den Planungsdaten bestmöglich zu erreichen, beispielsweise in dem ein Vergleich der Planungsdaten mit der realen relativen Lage des Schalungselements und des Bewehrungselements zueinander durchgeführt und auf eine minimale Abweichung bzw. Deckung gebracht wird. Insoweit kann die halbautomatische Fertigung in diesem Verfahrensschritt einen Optimierungsprozess zur Anordnung des Bewehrungselements, insbesondere mit einer Minimierung von Abweichungen der realen relativen Lage von Schalungselement und Bewehrungselement im Hinblick bzw. Unterschied auf die relative Lage von Schalungselement und Bewehrungselement zueinander gemäß Planungsdaten, durchführen. Es kann ein Optimierungsverfahren für die Abweichungen durchgeführt werden, insbesondere kann das Bewehrungselement so lange bewegt und/oder ausgerichtet werden, bis die Summe der Abweichungen zu den Planungsdaten ein Minimum annimmt. Zur Bestimmung der relativen Lage von Schalungselement und Bewehrungselement können die Lage des Schalungselements und des Bewehrungselements in Relation gesetzt werden, insbesondere mittels Verwendung eines oder mehrerer fester Referenzpunkte gegenüber dem bzw. denen die Lage von Schalungselement und Bewehrungselement ermittelt oder bestimmt werden kann. Daten der Vorrichtung, die das Bewehrungselement im Raum anordnen kann, beispielsweise der Roboterarm, können verwendet werden, um die Lage des Bewehrungselements im Raum anzugeben. Es kann vorgesehen sein, dass durch ein Ergreifen des Bewehrungselements an einer vorgegebenen Stelle des Bewehrungselements und eines Bewegens des Roboterarms aus einer bekannten Position in eine andere Position die Lage des Bewehrungselements im Raum bestimmbar ist. Alternativ oder zusätzlich kann die Positionierung des Bewehrungselements im Raum mittels eines am Bewehrungselement angeordneten und ermittelten Informationsträgers bestimmt werden.

Die reale ermittelte relative Lage des Schalungselements zum Bewehrungselement im Raum wird mit den Planungsdaten abgeglichen. Hierdurch kann eine Güte bzw. Qualität und/oder Abweichung der Einbausituation des Bewehrungselements ermittelt werden. Beispielsweise kann festgestellt werden, inwieweit ein in dem Schalungselement angeordnetes Bewehrungselement hinsichtlich der geplanten Lage abweicht.

In einer bevorzugten Ausführungsform werden Daten der Identifikation des Schalungselements und/oder des Bewehrungselements zusammen mit Daten für die relative Lage des Schalungselements und des Bewehrungselements dem Beton-Bauteil oder Bauabschnitt zugeordnet und gespeichert. Hierdurch kann die Fertigungs-Historie eines Beton-Bauteils oder eines Bauabschnitts festgehalten und nachvollzogen werden. Beispielsweise können die Daten in einer Datenbank, beispielsweise in Form einer Tabelle, gespeichert werden, die auf einem Computer, einem Server oder in einer Cloud hinterlegt sein kann.

In einer bevorzugten Ausführungsform können die einem Beton-Bauteil oder Bauabschnitt zugeordneten und gespeicherten Daten für eine Bewehrungsabnahme verwendet werden. Eine genaue Ermittlung der relativen Lage von Bewehrungselement und Schalungselement kann Aussagen darüber zulassen, ob eine Abnahme der Bewehrung erfolgen kann.

In einer bevorzugten Ausführungsform werden die Daten einem hergestellten Beton-Bauteil oder Bauabschnitt eineindeutig zugeordnet, welches die Ermittlung oder Bestimmung der Fertigungs-Historie nicht nur gruppenspezifisch, sondern auch individuell für jedes Beton-Bauteil oder Bauabschnitt ermöglicht. In Abkehr von der üblichen Auffassung insbesondere Beton-Bauteile in einer Gruppe oder Charge zu klassifizieren, kann jedem einzelnen betrachteten Beton-Bauteil eine Eigenschaft und/oder eine Güte zugeordnet sein.

In einer bevorzugten Ausführungsform kann durch eine eineindeutige Zuordnung das Beton-Bauteil oder der Bauabschnitt hinsichtlich seines Herstellungsprozesses bei seiner Verwendung verfolgt werden. Es wird gleichsam ein digitaler Zwilling bzw. ein digitales Abbild erzeugt, welches dem realen Beton-Bauteil oder Bauabschnitt zugeordnet ist.

In einer bevorzugten Ausführungsform wird das Beton-Bauteil oder der Bauabschnitt aufgrund der Daten und der eineindeutigen Zuordnung hinsichtlich seiner Verwendung umgenutzt. Die eineindeutige Zuordnung der Fertigungs-Historie ermöglicht es, die Qualität des Beton-Bauteils oder Bauabschnitts bei einer Umnutzung zu berücksichtigen und - wenn die Qualität dies zulässt - das entsprechende Beton-Bauteil oder den Bauabschnitt anders zu nutzen. Eine erhöhte Qualität des Beton-Bauteils oder Bauabschnitts ermöglicht ein "upgraden" zu einer höherwertigen oder zumindest gleichwertigen Nutzung.

In einer bevorzugten Ausführungsform wird das Bewehrungselement mit einer Abweichung von den Planungsdaten von kleiner gleich +/- 5mm, insbesondere kleiner gleich +/- 4mm, insbesondere kleiner gleich +/- 3mm, insbesondere +/- 2mm angeordnet. Es können geringe Toleranzen eingestellt bzw. erzielt werden. Die geringen Toleranzen können im Umkehrschluss eine Verbesserung der Planung bewirken, was zunächst widersinnig erscheint, aber da die geringen Toleranzen eingestellt werden können, muss keine "Verschlechterung" bei der Herstellung des Beton-Bauteils oder des Bauabschnitts eingeplant werden. Eine "großzügigere Planung" kann unterbleiben, wodurch Ressourcen eingespart werden können.

In einer bevorzugten Ausführungsform ist die Struktur bzw. der Informationsträger am Schalungselemente oder dem Bewehrungselement als mindestens eine der folgenden Strukturen bereitgestellt: Farbige Ausgestaltung, kontrastierende Ausgestaltung, codierte Markierung, mattierte/reflektierende Ausgestaltung, äußere Abmessung und Oberflächenstrukturierung. Eine geeignete Wahl einer Struktur bzw. die Nutzung einer schon vorhandenen Oberflächenstrukturierung und/oder äußere Abmessungen können bei einer Ermittlung der Identifikation bzw. der Lage genutzt werden. Der Informationsträger kann alternativ oder zusätzlich als Markierung, QR-Code, Hologramm, Sensorik, Aktorik oder RFID ausgestaltet sein. Eine Auswertung bzw. Ermittlung der relativen Lage des Elements kann beispielsweise dadurch erfolgen, dass der Informationsträger mittels eines Sensors, beispielsweise eines optischen Sensors, erfasst wird, wobei zudem für das Element bekannt sein kann, wo der Informationsträger relativ am Element angeordnet ist. Durch einen Vergleich des, beispielsweise optisch erfassten, Informationsträgers mit einem für den Informationsträger vorhandenen Abbild, das insbesondere von vorne ohne Verdrehung und/oder Verkippung vorliegt, kann eine Verdrehung und/oder Verkippung im Raum des Informationsträgers ermittelt werden. Durch die Angabe, wo der Informationsträger am Element angeordnet ist und wie der Informationsträger im Raum liegt, kann die relative Lage des Elements, insbesondere zu einem durch den Sensor ebenfalls ermittelten Referenzpunkts bzw. eines Informationsträgers an diesem Referenzpunkt, ermittelt werden.

Der Informationsträger kann sowohl die Information zur Ermittlung der räumlichen Lage beinhalten als auch eine Identifikation, um welches Element es sich, insbesondere bei einer eineindeutigen Zuordnung, handelt.

Der Informationsträger kann auch eine Kombination einer optisch erkennbaren Markierung bzw. Struktur und einem elektronisch erfassbaren Sender, beispielsweise einem RFID-Chip, aufweisen. Eine derartige Kombination bietet die Möglichkeit, dass die Information hinsichtlich der Lage im Raum und die Information über die Identifikation getrennt werden kann. Insbesondere kann eine Kombination eines Informationsträgers für einen am Bewehrungselement angebrachten Informationsträger vorgesehen sein. Eine optisch erkennbare Markierung ist einfach herstellbar und auch einfach an einem Element in einer bestimmten Ausrichtung und Position anbringbar. Ein, insbesondere elektronisch erfassbarer, Sensor kann als Sender ausgestaltet sein, der eine räumlich inhomogene Abstrahlcharakteristik aufweist. Ein elektronisch erfassbarer Sender kann die Möglichkeit bieten, auch nach dem Verfüllen mittels Beton und damit der Herstellung des Beton-Bauteils und/oder des Bauabschnitts erfasst zu werden. Durch eine eineindeutige Zuordnung des Informationsträgers kann, insbesondere bei einem elektronisch erfassbaren Sender, auch nach der Fertigstellung bzw. Herstellung die räumliche Lage ermittelt und/oder die Identität des Bewehrungselements bestimmt werden. Dies kann einen Vorteil schaffen, wenn beispielsweise eine Abnahme durch den Statiker auf der Baustelle vor dem Einbau eines Beton-Bauteils nicht erfolgt ist. Mittels einer eineindeutigen Zuordnung kann beispielsweise der Statiker eine Abnahme dennoch durchführen, wenn er erkennt, dass das geplante Bewehrungselement an der Baustelle richtig angeordnet ist.

Es wird auch eine Verwendung eines Schalungselements und eines Bewehrungselements bei der Herstellung eines mittels Planungsdaten geplanten Beton-Bauteils oder Bauabschnitts beschrieben. Das Schalungselement ist geeignet zur Bildung zumindest eines Abschnitts einer Schalung, in die das Bewehrungselement angeordnet und Beton eingefüllt werden kann. Das Schalungselement und/oder dass mindestens eine Bewehrungselement weist einen Informationsträger bzw. eine Struktur auf. Der Informationsträger des Schalungselements und/oder des Bewehrungselements wird dazu verwendet: i) das Schalungselement und/oder das Bewehrungselement zu identifizieren und/oder ii) die Lage des Schalungselements und/oder des Bewehrungselements im Raum zu ermitteln und iii) die relative Lage des Schalungselements zum Bewehrungselement im Raum in Abhängigkeit von den Planungsdaten mittels eines Sensors zu bestimmen.

Die Erfindung schafft auch ein System zur Herstellung eines mittels Planungsdaten geplanten Beton-Bauteils oder Bauabschnitts gemäß Anspruch 11.

Sofern in der Beschreibung ein Verfahren, eine Verwendung und ein System beschrieben werden, so ergänzen die Ausführungen der einzelnen Aspekte einander.

Die vorstehenden Ausführungen stellen ebenso wie die nachfolgende Beschreibung beispielhafter Ausführungsformen keinen Verzicht auf bestimmte Ausführungsform oder Merkmale dar.
- Fig. 1a), b) und c): zeigen ein Schalungselement, ein Bewehrungselement und ein Beton-Bauteil in einer schematischen isometrischen Ansicht; und
- Fig. 2: zeigt das Schalungselement und das Bewehrungselement von Fig. 1a) bzw. 1b) vor einem Verfüllen einer Schalung mit Beton und einen Sensor.

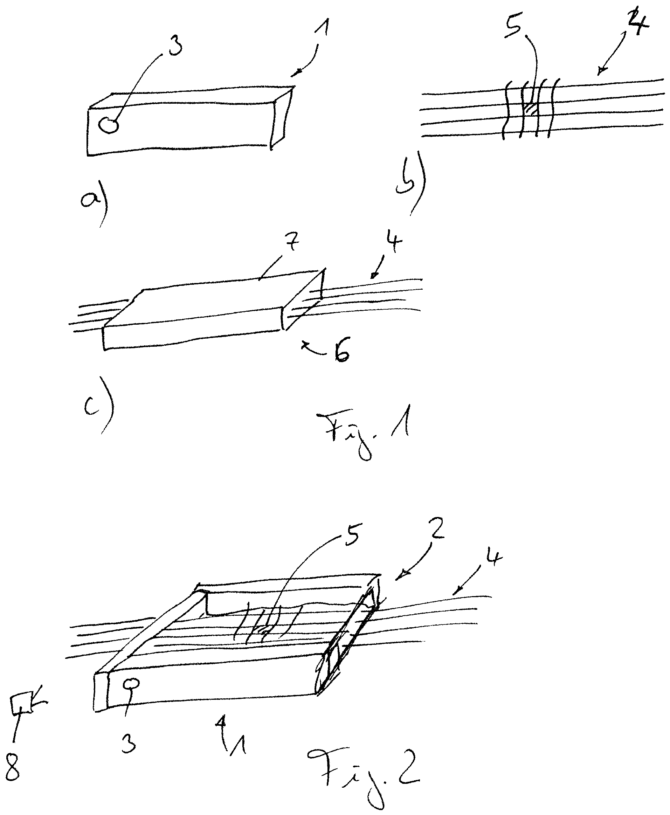

Fig. 1a) zeigt ein Schalungselement 1 einer Schalung 2 mit einem Informationsträger 3. Der Informationsträger 3 ist an dem Schalungselement 1 an einer vorbestimmten, festgelegten Position und Ausrichtung angebracht.

Mittels des Informationsträgers 3 kann eine Identifizierung des Schalungselements 1 vorgenommen werden.

Fig. 1b) zeigt ein Bewehrungselement 4, an dem ein Informationsträger 5 an einer vorbestimmten, festgelegten Position und Ausrichtung angebracht ist.

Mittels des Informationsträgers 5 kann eine Identifizierung des Bewehrungselements 4 vorgenommen werden.

Fig. 1c) zeigt ein Beton-Bauteil 6, in welchem das Bewehrungselement 4 in Beton 7 zumindest teilweise vergossen ist.

Fig. 2 zeigt das Bewehrungselement 4 in einer Schalung 2, die zumindest abschnittsweise durch das Schalungselement 1 gebildet ist. Ein Sensor 8, der als Kamera ausgebildet ist, kann die Informationsträger 3 und 5 optisch erfassen. Mittels eines Vergleichs der Abbilder der ohne Verkippung und Verdrehung optisch erfassten Informationsträger 3 und 5 kann die relative Lage der Informationsträger 3 und 5 zum Sensor 8 ermittelt werden. Werden die Informationsträger 3 und 5 unter gleicher Position und Ausrichtung des Sensors 8 erfasst, ist die relative Lage zwischen Bewehrungselement 4 und Schalungselement 1 bestimmbar und kann mit Planungsdaten, die eine Vorgabe für das Beton-Bauteil 6 machen hinsichtlich Anordnung des Bewehrungselements 4 im Beton-Bauteil 6 und Spezifizierung, welches Bewehrungselement 4 zur Herstellung verwendet werden soll, abgeglichen werden.

## Patentansprüche

1. Verfahren zum Herstellen eines Beton-Bauteils (6) oder Bauabschnitts nach Planungsdaten, wobei das Verfahren umfasst:
- Bereitstellen eines Schalungselements (1) zur Bildung einer Schalung (2) für mindestens ein Bewehrungselement (4) und Beton,
- Bereitstellen des Bewehrungselements (4),
wobei das Schalungselement (1) einen Informationsträger (3, 5) aufweist, wobei anhand des Informationsträgers (3, 5) des Schalungselements (1) die Lage des Schalungselements (1) im Raum ermittelt wird,
**dadurch gekennzeichnet, dass**
das Bewehrungselement (4) einen Informationsträger (3, 5) aufweist,
und nach der Ermittlung der Lage des Schalungselements (1) im Raum ein virtuelles Bewehrungselement in Abhängigkeit der Lage des Schalungselements (1) in das Schalungselement (1) gemäß den Planungsdaten projiziert wird, und dann das Bewehrungselement (4) in der Schalung (2) angeordnet wird,
wobei durch einen mit den Informationsträgern (3, 5) des Schalungselements (1) und des Bewehrungselements (4) zusammenwirkenden Sensor die reale relative Lage des Schalungselements (1) zum Bewehrungselement (4) im Raum in Abhängigkeit von den Planungsdaten bestimmt wird,
wobei die reale ermittelte relative Lage des Schalungselements (1) zum Bewehrungselement (4) im Raum mit den Planungsdaten abgeglichen wird.

2. Verfahren nach Anspruch 1, wobei das Bewehrungselement (4) an einem einbaufertigen Bauteil (6) bereitgestellt wird, und das einbaufertige Bauteil (6) aus der folgenden Gruppe ausgewählt wird: Tragendes Wärmedämmelement, Trittschallelement, thermisch trennendes Befestigungselement, Schub- und Schwerlastdorn, Transportankerhülse, Ankerschiene, Gitterhülse und Durchstanzbewehrung.

3. Verfahren nach Anspruch 1 oder 2, wobei das Bewehrungselement (4) in Abhängigkeit von der ermittelten Lage des Schalungselements (1) zum Schalungselement (1) automatisch gemäß den Planungsdaten angeordnet wird.

4. Verfahren nach einem der Ansprüche 1 bis 3, wobei Daten der Identifikation des Schalungselements (1) und/oder des Bewehrungselements (4) zusammen mit Daten für die relative Lage des Schalungselements (1) und des Bewehrungselements (4) dem Beton-Bauteil (6) oder Bauabschnitt zugeordnet und gespeichert werden

5. Verfahren nach Anspruch 4, wobei die Daten für eine Bewehrungsabnahme verwendet werden.

6. Verfahren nach Anspruch 4 oder 5, wobei die Daten einem hergestellten Beton-Bauteil (6) oder Bauabschnitt eineindeutig zugeordnet werden.

7. Verfahren nach Anspruch 6, wobei das Beton-Bauteil (6) oder der Bauabschnitt aufgrund der eineindeutigen Zuordnung hinsichtlich seines Herstellungsprozesses bei seiner Verwendung verfolgt wird.

8. Verfahren nach Anspruch 6 oder 7, wobei das Beton-Bauteil (6) oder der Bauabschnitt aufgrund der Daten und der eineindeutigen Zuordnung hinsichtlich seiner Verwendung umgenutzt wird.

9. Verfahren nach einem der Ansprüche 1 bis 8, wobei das eine Bewehrungselement (4) mit einer Abweichung von den Planungsdaten von kleiner als +/- 5mm, insbesondere kleiner gleich +/- 4mm, insbesondere kleiner gleich +/- 3mm, insbesondere +/- 2mm angeordnet wird.

10. Verfahren nach einem der Ansprüche 1 bis 9, wobei der Informationsträger (3, 5) am Schalungselement (1) oder dem Bewehrungselement (4) als mindestens einer der folgenden Informationsträger (3, 5) bereitgestellt wird: Farbige Ausgestaltung, kontrastierende Ausgestaltung, codierte Markierung, mattierte/reflektierende Ausgestaltung, äußere Abmessung, Oberflächenstrukturierung, Markierung, QR-Code, Hologramm, Sensorik, Aktorik und RFID.

11. System zur Herstellung eines Beton-Bauteils (6) oder Bauabschnitts nach Planungsdaten, umfassend ein Schalungselement (1) welches eine Schalung (2) ausbildet, in die Beton eingefüllt werden kann, und ein in der Schalung (2) angeordnetes Bewehrungselement (4), wobei das Schalungselement (1) einen Informationsträger (3, 5) aufweist, anhand dessen die Lage des Schalungselements (1) im Raum ermittelt werden kann, **dadurch gekennzeichnet, dass**
das Bewehrungselement (4) einen Informationsträger (3, 5) aufweist,
wobei das System angepasst ist, anhand des Informationsträgers (3, 5) des Schalungselements (1) und des Bewehrungselements (4)
die reale relative Lage des Schalungselements (1) zum Bewehrungselement (4) im Raum in Abhängigkeit von den Planungsdaten mittels eines mit den Informationsträgern des Schalungselements (1) und des Bewehrungselements (4) zusammenwirkenden Sensors (8) des Systems zu bestimmen,
wobei das System dazu eingerichtet ist, ein virtuelles Bewehrungselement in Abhängigkeit der Lage des Schalungselements (1) in das Schalungselement (1) gemäß den Planungsdaten zu projizieren,
wobei Mittel des Systems vorgesehen sind, die für einen Abgleich der realen ermittelten relativen Lage des Schalungselements (1) zum Bewehrungselement (4) im Raum mit den Planungsdaten ausgestaltet sind.

## Claims

1. Method for producing a concrete component (6) or construction section according to planning data, wherein the method comprises:
- providing a formwork element (1) to form a mould (2) for at least one reinforcement element (4) and concrete,
- providing the reinforcement element (4),
wherein the formwork element (1) has an information carrier (3, 5), wherein based on the information carrier (3, 5) of the formwork element (1), the position of the formwork element (1) in space is determined,
**characterized in that**
the reinforcement element (4) has an information carrier (3, 5),
and after determining the position of the formwork element (1) in space, a virtual reinforcement element is projected into the formwork element (1) according to the planning data, depending on the position of the formwork element (1), and then the reinforcement element (4) is arranged in the mould (2),
wherein a sensor interacting with the information carriers (3, 5) of the formwork element (1) and the reinforcement element (4) determines the actual relative position of the formwork element (1) to the reinforcement element (4) in space depending on the planning data,
wherein the actual position of the formwork element (1) determined relative to the reinforcement element (4) in space is compared with the planning data.

2. Method according to Claim 1, wherein the reinforcement element (4) is provided on a prefabricated component (6), and the prefabricated component (6) is selected from the following group: load-bearing thermal insulation element, impact sound element, thermally separating fastening element, shear and heavy load dowel, transport anchor sleeve, anchor channel, grid sleeve and punching shear reinforcement.

3. Method according to Claim 1 or 2, wherein the reinforcement element (4) is automatically arranged in relation to the formwork element (1) according to the planning data, depending on the determined position of the formwork element (1).

4. Method according to any one of Claims 1 to 3, wherein data for the identification of the formwork element (1) and/or the reinforcement element (4) together with data for the relative position of the formwork element (1) and the reinforcement element (4) are assigned to and stored with the concrete component (6) or construction section.

5. Method according to Claim 4, wherein the data is used for reinforcement acceptance.

6. Method according to Claim 4 or 5, wherein the data is uniquely assigned to a manufactured concrete component (6) or construction section.

7. Method according to Claim 6, wherein the concrete component (6) or construction section is tracked during its use based on its unique assignment in terms of its manufacturing process.

8. Method according to Claim 6 or 7, wherein the concrete component (6) or the construction section is repurposed based on the data and the unique assignment in terms of its use.

9. Method according to any one of Claims 1 to 8, wherein the reinforcement element (4) is arranged with a deviation from the planning data of less than +/- 5mm, in particular less than or equal to +/- 4mm, in particular less than or equal to +/- 3mm, in particular +/- 2mm.

10. Method according to any one of Claims 1 to 9, wherein the information carrier (3, 5) on the formwork element (1) or the reinforcement element (4) is provided as at least one of the following information carriers (3, 5): coloured design, contrasting design, coded marking, matted/reflective design, external dimension, surface structuring, marking, QR code, hologram, sensor, actuator and RFID.

11. System for manufacturing a concrete component (6) or construction section according to planning data, comprising a formwork element (1) which forms a mould (2) into which concrete can be poured, and a reinforcement element (4) arranged in the mould (2), wherein the formwork element (1) has an information carrier (3, 5), based on which the position of the formwork element (1) in space can be determined, **characterized in that**
the reinforcement element (4) has an information carrier (3, 5),
wherein the system is adapted,
based on the information carrier (3, 5) of the formwork element (1) and the reinforcement element (4),
to determine the actual relative position of the formwork element (1) to the reinforcement element (4) in space depending on the planning data by means of a sensor (8) of the system interacting with the information carriers of the formwork element (1) and the reinforcement element (4),
wherein the system is set up to project a virtual reinforcement element into the formwork element (1) according to the planning data depending on the position of the formwork element (1),
wherein means of the system are provided which are designed to compare the actual position of the formwork element (1) determined relative to the reinforcement element (4) in space with the planning data.

## Revendications

1. Procédé de fabrication d'un composant en béton (6) ou d'une section de construction selon les données de planification, le procédé comprenant :
- Mise à disposition d'un élément de coffrage (1) pour former un coffrage (2) pour au moins un élément d'armature (4) et du béton,
- Mise à disposition de l'élément d'armature (4),
l'élément de coffrage (1) présentant un support d'informations (3, 5), la position de l'élément de coffrage (1) dans l'espace étant déterminée à l'aide du support d'informations (3, 5) de l'élément de coffrage (1),
**caractérisé en ce que**
l'élément d'armature (4) présente un support d'informations (3, 5), et après la détermination de la position de l'élément de coffrage (1) dans l'espace, un élément d'armature virtuel est projeté dans l'élément de coffrage (1) en fonction de la position de l'élément de coffrage (1) selon les données de planification, puis l'élément d'armature (4) est disposé dans le coffrage (2),
la position relative réelle de l'élément de coffrage (1) par rapport à l'élément d'armature (4) dans l'espace étant déterminée en fonction des données de planification par un capteur interagissant avec les supports d'informations (3, 5) de l'élément de coffrage (1) et de l'élément d'armature (4),
la position relative réelle déterminée de l'élément de coffrage (1) par rapport à l'élément d'armature (4) dans l'espace étant comparée avec les données de planification.

2. Procédé selon la revendication 1, dans lequel l'élément d'armature (4) est mis à disposition sur un composant (6) prêt à être installé, et le composant (6) prêt à être installé est choisi dans le groupe suivant : Elément d'isolation thermique porteur, élément d'isolation acoustique, élément de fixation à rupture de pont thermique, goujon de cisaillement et goujon pour charges lourdes, douille d'ancrage de transport, rail d'ancrage, douille à treillis et armature de poinçonnement.

3. Procédé selon la revendication 1 ou 2, dans lequel l'élément d'armature (4) est disposé automatiquement selon les données de planification en fonction de la position déterminée de l'élément de coffrage (1) par rapport à l'élément de coffrage (1).

4. Procédé selon l'une des revendications 1 à 3, dans lequel des données d'identification de l'élément de coffrage (1) et/ou de l'élément d'armature (4) sont associées au composant en béton (6) ou à la section de construction et sont mémorisées en même temps que des données pour la position relative de l'élément de coffrage (1) et de l'élément d'armature (4).

5. Procédé selon la revendication 4, dans lequel les données sont utilisées pour une réception d'armature.

6. Procédé selon la revendication 4 ou 5, dans lequel les données sont attribuées de manière univoque à un composant en béton (6) fabriqué ou à une section de construction.

7. Procédé selon la revendication 6, dans lequel le composant en béton (6) ou la section de construction est suivi lors de son utilisation sur la base de l'attribution univoque en ce qui concerne son processus de fabrication.

8. Procédé selon la revendication 6 ou 7, dans lequel le composant en béton (6) ou la section de construction est réutilisé en ce qui concerne son utilisation sur la base des données et de l'attribution univoque.

9. Procédé selon l'une des revendications 1 à 8, dans lequel l'un des éléments d'armature (4) est disposé avec un écart par rapport aux données de planification inférieur à +/- 5 mm, notamment inférieur ou égal à +/- 4 mm, notamment inférieur ou égal à +/- 3 mm, notamment +/- 2 mm.

10. Procédé selon l'une des revendications 1 à 9, dans lequel le support d'informations (3, 5) est mis à disposition sur l'élément de coffrage (1) ou l'élément d'armature (4) en tant qu'au moins un des supports d'informations (3, 5) suivants : Coloration, contraste, marquage codé, finition mate/réfléchissante, dimensions extérieures, structure de surface, marquage, code QR, hologramme, capteurs, actionneurs et RFID.

11. Système pour la fabrication d'un composant en béton (6) ou d'une section de construction selon les données de planification, comprenant un élément de coffrage (1) qui forme un coffrage (2) dans lequel du béton peut être versé, et un élément d'armature (4) disposé dans le coffrage (2), l'élément de coffrage (1) présentant un support d'informations (3, 5) à l'aide duquel la position de l'élément de coffrage (1) dans l'espace peut être déterminée, **caractérisé en ce que**
l'élément d'armature (4) présente un support d'informations (3, 5),
le système étant adapté,
pour déterminer, à l'aide du support d'informations (3, 5) de l'élément de coffrage (1) et de l'élément d'armature (4), la position relative réelle de l'élément de coffrage (1) par rapport à l'élément d'armature (4) dans l'espace en fonction des données de planification au moyen d'un capteur (8) du système interagissant avec les supports d'informations de l'élément de coffrage (1) et de l'élément d'armature (4),
le système étant adapté pour projeter un élément d'armature virtuel en fonction de la position de l'élément de coffrage (1) dans l'élément de coffrage (1) conformément aux données de planification,
des moyens du système étant prévus, qui sont conçus pour comparer la position relative réelle déterminée de l'élément de coffrage (1) par rapport à l'élément d'armature (4) dans l'espace avec les données de planification.
